# EUROPÄISCHE PATENTSCHRIFT

(11) **EP 2 487 435 B1**
(45) Veröffentlichungstag und Bekanntmachung des Hinweises auf die Patenterteilung: **28.08.2013**
(21) Anmeldenummer: 11001119.4
(22) Anmeldetag: 11.02.2011
(51) Int. Cl.: F24J 2/52

(54) **Klemmverbindung zur Befestigung von plattenförmigen Bauelementen insbesondere von Solarmodulen**
Clamping joint for fastening board-shaped construction elements particularly solar modules
Liaison de serrage pour la fixation de composants en forme de plaques, notamment de modules solaires

(43) Veröffentlichungstag der Anmeldung: 15.08.2012
(73) Patentinhaber: Carl Freudenberg KG, 69469 Weinheim (DE)
(72) Erfinder: Barth, Armin, 69517 Gorxheimertal (DE)

(56) Entgegenhaltungen:
- EP-A1- 2 309 552
- DE-U1-202009 013 609
- DE-U1-202010 000 121
- DE-U1-202010 000 208
- FR-A1- 2 944 817
- US-A1- 2009 200 443

## Beschreibung

### Technisches Gebiet

Die Erfindung betrifft eine Klemmverbindung zur Befestigung von plattenförmigen Bauelementen, insbesondere von Solarmodulen auf schienenförmigen, mit Führungsnuten mit nach innen in die Nut überstehenden Rändern versehenen Trägem, aus einer Auflage mit wenigstens einer auf ihrer Oberseite vorhandenen Auflagenfläche für ein Bauelement und mit einem die Auflagefläche bzw. -flächen begrenzenden Stützbalken sowie einem auf ihrer Unterseite vorhandenen Widerlager in T-Form, dessen Querbalken in Längsrichtung der Führungsnut ausgerichtet in die Führungsnut einsetzbar ist und nach einer Drehung um 90° die überstehenden Ränder der Führungsnut hintergreifen und aus einer Klemmkappe, mit die Auflagefläche bzw. -flächen abdeckenden Klemmfläche bzw. -flächen und einer den oberen Teil des Stützbalkens erfassenden Längsnut.

Klemmverbindungen zur Befestigung von plattenförmigen Bauelementen sind allgemein bekannt. In neuerer Zeit haben jedoch Klemmverbindungen für Solarmodule eine Sonderstellung erreicht. Bei diesen Klemmverbindungen ist es von besonderer Wichtigkeit, dass sie im Hinblick auf die entstehenden sehr hohen mechanischen Belastungen, beispielsweise durch Wind oder Schneefall, oder auch wegen der Größe und des Gewichts der Module sehr stabil sein sollen. Die Solarmodule sollen über die Klemmverbindungen fest verankert sein. Gleichzeitig aber besteht die Forderung, dass durch die Verklemmung keine Verspannungen an den Modulen aüftreten, die zu Rissbildungen an den sehr empfindlichen Oberflächen der Module führen können.

### Stand der Technik

Zum Stand der Technik wird auf die DE 20 2008 002 264 U1 und auf die US 2009/0200443 A1 verwiesen. Diese bekannten Klemmverbindungen sind wenig zufriedenstellend, insbesondere deshalb, weil sie aus einer Vielzahl von Einzelteilen bestehen, welche die vorort erforderliche Montage aufwendig gestalten. Durch die Vielzahl der Einzelteile ist das Handling während der Montage erschwert, insbesondere auch deshalb, weil die Montage in aller Regel auf schrägliegenden Trägern zu erfolgen hat. Die schräge Ausrichtung der Träger führt dazu, dass die Einzelteile sich ungewollt verschieben und immer wieder neu justiert werden müssen.

In unserer älteren Patentanmeldung EP-A-2 309 552, die als Stand der Technik gemäß Art. 54(3) EPC angesehen wird, ist eine verbesserte Klemmverbindung dargestellt, die einen einfachen Aufbau hat und die eine erleichterte Montage erlaubt. Diese Klemmverbindung besteht im Wesentlichen aus drei Teilen, nämlich einer Klemmauflage, einer Klemmkappe und einer Befestigungsschraube. Die Auflage hat an ihrer Unterseite ein Widerlager in T-Form, dessen Fuß von der Unterseite der Auflage absteht und einen Querbalken hat, der in die Führungsnut des Trägers eingesetzt die überstehenden Ränder der Führungsnut hintergreift. Auf diese Weise ist eine vereinfachte Montage der Klemmauflage am Träger möglich. An der Klemmauflage wird die Klemmkappe aufgesetzt und mittels der Befestigungsschraube daran verschraubt. Durch die Klemmkappe werden die Randseiten der Module erfasst und auf die Auflage angedrückt. Auf der Oberseite der Auflage ist ein längs zum Träger ausgerichteter Stützbalken vorhanden, an dem der Modulrand anliegt und der gleichzeitig als Abstandshalter für die aufgelegten Module vorgesehen ist.

### Darstellung der Erfindung

Der Erfindung liegt die Aufgabe zugrunde, die in der älteren Patentanmeldung dargestellte Klemmverbindung weiter zu verbessern, um ihre Montage weiter zu erleichtern, wobei gleichzeitig auch eine diebstahlssichere Befestigung erreicht werden soll.

Die Lösung der gestellten Aufgabe wird mit den Merkmalen des Anspruchs 1 erreicht. Die Unteransprüche 2 bis 17 stellen vorteilhafte Weiterbildungen des Erfindungsgedankens dar.

Als Ausgangslage für die vorliegende Erfindung wird die in der oben genannten älteren Anmeldung beschriebene Klemmverbindung verwendet. Diese Klemmverbindung besteht im Wesentlichen aus einer Auflage mit wenigstens einer auf ihrer Oberseite vorhandenen Auflagefläche für ein Bauelement, insbesondere einem Solarmodul, und einem die Auflagefläche bzw. -flächen begrenzenden in Längsrichtung der Auflage ausgerichteten Stützbalken. Auf ihrer Unterseite hat die Auflage das Widerlager in T-Form, das mit seinem Querbalken in die Führungsnut des Trägers eingesetzt wird. Die Klemmkappe hat eine bzw. mehrere Klemmflächen, welche den Auflageflächen an der Auflage gegenüberliegen und eine Längsnut, welche den oberen Teil des Stützbalkens einfassen. Bei der Auflage sind seitlich des Stützbalkens die Klemmflächen vorgesehen und zwar an jeder Seite eine, wenn durch die Klemmverbindung zwei Solarmodule erfasst werden sollen. Eine Klemmfläche ist vorgesehen, wenn die Klemmverbindung nur ein Solarmodul ergreifen soll, was der Fall ist, wenn es sich um ein Solarmodul handelt, das als Endstück in einer Reihe angeordnet ist. Nach der vorliegenden Erfindung wird die Klemmkappe und die Auflage über eine Rastverbindung miteinander fixiert. Für die Klemmverbindung sind folglich nur zwei Einzelteile vorgesehen, nämlich die Auflage und die Klemmkappe. An der Klemmkappe ist der Raststift angeordnet, vorzugsweise indem Klemmkappe und Raststift integral zu einer Einheit verbunden sind. In der Auflage ist eine Bohrung angebracht, in welche der Raststift eingedrückt wird. Sowohl am Raststift als auch in der Bohrung in der Auflage sind gegenläufig ausgerichtete Sägezähne angebracht, welche ein Eindrücken des Raststiftes in die Bohrung erlauben, jedoch einem Herausziehen des Raststiftes aus der Bohrung entgegenstehen. Eine Verschraubung der Teile entfällt, der Raststift wird lediglich in die Bohrung eingedrückt, um die Klemmkappe an der Auflage zu befestigen und damit gleichzeitig den Rand des anliegenden Solarmoduls zu erfassen. Die Ausbildung des Raststiftes und der Bohrung mit Sägezähnen hat den zusätzlichen Vorteil, dass verschiedene Stärken von Solarmodulen durch die Klemmverbindung erfasst werden können. Die Sägezähne in der Bohrung und am Stift lassen ein unterschiedlich tiefes Eindrücken des Raststiftes in die Bohrung zu, so dass Module mit unterschiedlicher Stärke festgeklemmt werden können.

In vielen Fällen ist es für die Klemmverbindung von Vorteil, wenn die Klemmkappe aus einem Kunststoff und die Auflage aus einem Elastomer hergestellt worden ist. Dieses erlaubt eine gewisse Elastizität der Klemmverbindung beim Einklemmen des Salarmoduls. Zur Unterstützung dieser Elastizität können die Auflageflächen mit Längsrillen versehen sein. Die Klemmflächen der Klemmkappe sind bevorzugt mit einem Silikonüberzug versehen, der ebenfalls eine gewisse Elastizität hat.

Um bei der Klemmverbindung eine starke Diebstahlsicherung zu erreichen, ist es von Vorteil, wenn in der Bohrung der Auflage ein Insert, beispielsweise aus einem Kunststoff, eingefügt ist. Der aus Kunststoff bestehende Raststift und das Insert aus Kunststoff verhindern in verstärktem Maße ein Entfernen der Klemmkappe. In diesem Zusammenhang ist es auch günstig, wenn das Insert mit seitlichen Auslegem versehen wird, die an der Unterseite des Querbalkens des Widerlagers anliegen. Schließlich ist es von Vorteil, wenn das Insert mit seinem unteren Rand am Boden der Führungsnut anliegt und dadurch zusätzlich einen Widerstand der Auflage beim Eindrücken des Raststiftes erzeugt.

Für den Fall, dass die Klemmverbindung für Module mit gleichbleibender Stärke vorgesehen ist, ist es vorteilhaft, wenn die Rastverbindung aus einem Raststift besteht, der an seinem Ende Rastnasen hat, welche in Einschnitte am unteren Rand der Bohrung oder an einem Hinterschnitt in der Bohrung einrasten.

Um das Eindrücken des Raststiftes in die Bohrung der Auflage zu erleichtern, wird der Raststift über die Länge der Sägezähne bzw. der Rastnasen mit mindestens einem Längsschlitz versehen. Bevorzugt werden jedoch zwei sich kreuzende Längsschlitze angebracht. Durch ein leichtes Zusammendrücken der durch die Längsschlitze geteilten Teile des Raststiftes wird seine Einführung in die Bohrung erleichtert.

Eine zusätzliche Sicherung der Klemmkappe an der Auflage wird dadurch erreicht, dass die Klemmkappe auf ihrer Unterseite Längsrillen mit Hinterschneidungen hat, hinter welche am oberen Teil des Stützbalkens vorhandene Widerhaken einklipsbar sind: Diese Widerhaken erstrecken sich vorzugsweise über die gesamte Länge der Längsrillen.

Zur Verstärkung der Festigkeit der Auflage kann dieselbe mit einem Stützblech versehen sein, welches sich sowohl im Bereich der Auflageflächen als auch im Bereich des Stützbalkens erstreckt und das in die Auflage selbst eingebettet ist. Sowohl dieses Stützblech als auch das Insert können in die Auflage in einem Vulkanisationsverfahren eingefügt werden.

### Kurzbeschreibung der Zeichnung

In der beiliegenden Zeichnung wird In mehreren Ausführungsformen die Erfindung schematisch dargestellt.

Es zeigt:
- Fig.1: eine Schrägansicht der an einem Träger befestigten Klemmverbindung;
- Fg. 2: einen Querschnitt durch die Klemmverbindung mit einer Rastverbindung über eine Rastverzahnung;
- Fig. 3: einen Querschnitt durch eine Rastverbindung mittels eines Raststiftes mit Rastnasen an seinem unteren Ende;
- Fig. 4: einen vergrößerten Ausschnitt der Rastverbindung nach Fig. 3;
- Fig. 5: eine vergrößerte Darstellung eines Abschnitts der Klemmkappe mit der Anordnung der Längsrillen und der Widerhaken.

### Ausführung der Erfindung

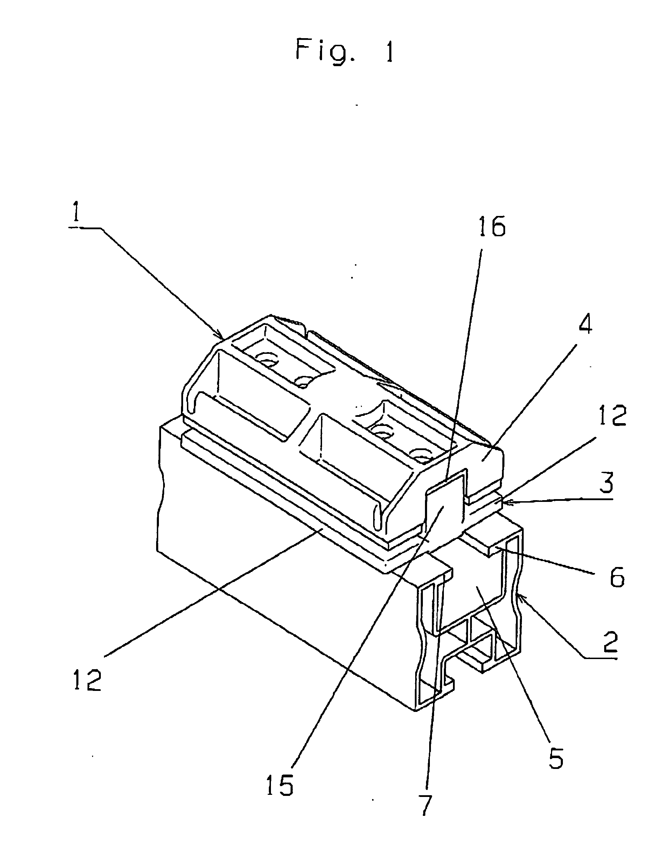

Die Fig. 1 zeigt in der Schrägansicht die Klemmverbindung 1 angeordnet auf einem Teilabschnitt eines Trägers 2. In die Klemmverbindung 1 können in bekannter Weise Solarmodule eingefügt und darin festgeklemmt werden. Die Solarmodule sind hier nicht gezeigt. Die Klemmverbindung 1 selbst besteht aus der Auflage 3 und der Klemmkappe 4. Die Träger 2 sind Strangprofile mit einer Führungsnut 5, die nach innen überstehende Ränder 6 und 7 hat. Die Auflage 3 hat die seitlich vorstehenden Auflageflächen 12 und den Stützbalken 15. Der Stützbalken 15 liegt mit seinem oberen Teil in der Längsnut 16 der Klemmkappe 4.

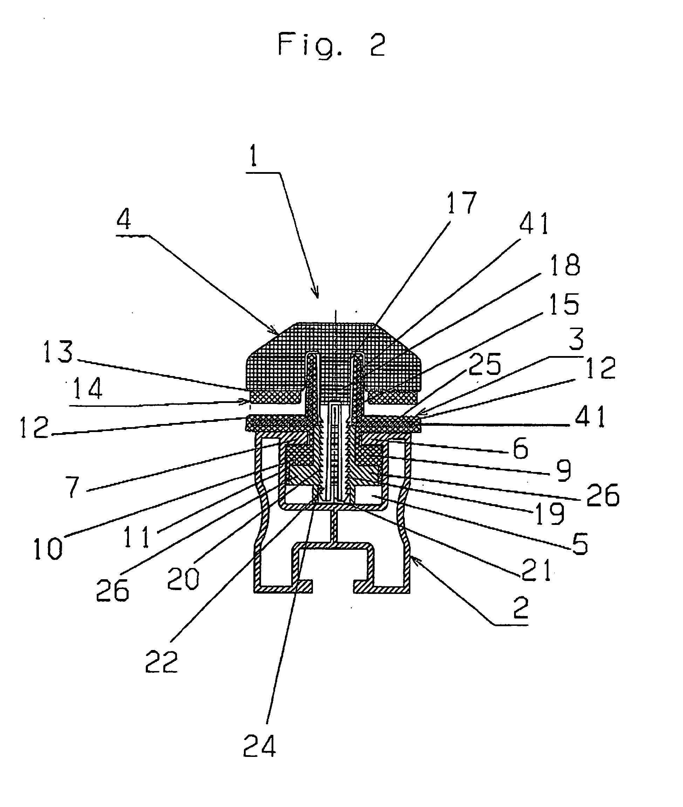

In der Fig. 2 Ist ein Querschnitt durch die Klemmverbindung 1 in ihrer Mitte gezeigt. Sichtbar sind hier die Auflage 3 mit den Auflageflächen 12, dem Stützbalken 15, dem Widerlager 9 und dem insert 24, sowie die Klemmkappe 4 mit dem Raststift 18. Der Raststift 18 ist in die mittig in der Auflage 3 befindliche Bohrung 17 eingedrückt. Der Raststift 18 hat die Rastverzahnung 19, während in der Bohrung 17 die Rastverzahnung 20 angebracht ist. Letztere befindet sich im vorliegenden Fall in dem Insert 24. Beide Rastverzahnungen 19 und 20 sind kompatibel und aus gegenläufig ausgerichteten Sägezähnen. Der Raststift 18 ist über die Länge, welcher von der Rastverzahnung erfasst wird, mit zwei Längsschlltzen 21 versehen, welche bevorzugt im Winkel von 90° zueinander ausgerichtet sind. Die Längsschlitze 21 erlauben ein radiales Zusammendrücken der durch die Längsschlitze 21 entstandenen Hakenarme 22. Im Ausführungsbeispiel wird der Sägezahnabschnitt in der Bohrung 17 der Auflage durch ein Insert 24 aus Kunststoff gebildet. Das an der Unterseite der Auflage 3 vorhandene Widerlager 9 ist T-förmig ausgebildet. Der Fuß 10 des Widerlagers 9 kommt unterhalb der Ränder 6 und 7 des Trägers 2 zur Anlage, wenn der Querbalken 11 der T-Form in der Führungsnut 5 liegt. Beim Anbringen der Auflage 3 am Träger 2 wird die Klemmkappe 4 zunächst quer zum Träger 2 ausgerichtet, so dass der Querbalken 11 in Längsrichtung in die Führungsnut 5 eingeschoben werden kann. Nach dem Einführen des Widerlagers 9 in die Führungsnut 5 wird die Klemmkappe 4 und damit auch der Querbalken 11 um 90° gedreht, so dass die Klemmkappe 4 in Längsrichtung des Trägers 2 ausgerichtet ist. Die Klemmkappe 4 selbst Ist aus einem Kunststoff. Ihre Klemmflächen 13 sind mit einem Silikonüberzug 14 versehen. Auf den Oberflächen der Auflage 3 sind die längsrillen 25 vorgesehen. Diese Längsrillen 25 in Verbindung mit den Silikonüberzügen 14 an der Klemmkappe 4 ergeben ein leicht nachgiebiges sicheres Einklemmen der Solarmodule. Die Solarmodule werden auf diese Weise zwischen Klemmkappe 4 und Auflage 3 zerstörungsfrei gehalten. Die Auflage 3 ist außerdem mit einem Stützblech 41 versehen, welches die Festigkeit der Auflage 3 unterstützt. Das Stützblech 41 und auch das Insert 24 sind durch Vulkanisation in bzw. an der Auflage 3 befestigt. Das Insert 24 hat die seitlichen Ausleger 26, die von ihrer Gestalt her an die Querbalken 11 angepasst sind. Sie liegen an der Unterseite des Querbalkens 11 des Widerlagers 9 an und sind auf ihren Außenseiten von dem Elastomer der Auflage 3 ummantelt. Das Insert 24 stützt sich mit seinem unteren Rand am Boden der Führungsnut 5 ab.

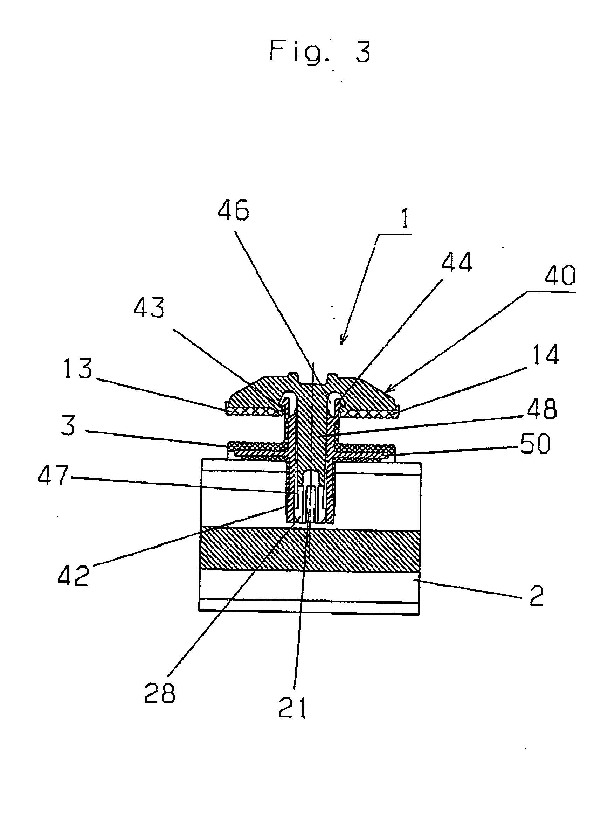

Die Klemmverbindung nach der Fig. 3 ist in ihrem prinzipiellen Aufbau vergleichbar mit der Fig. 2. Anders ist hier die Rastverbindung, die aus einem Raststift 48 besteht, der anstelle der Sägezähne mit Rastnasen 28 an seinem unteren Ende versehen ist. Im Bereich der Rastnasen 28 sind hier ebenfalls kreuzförmig die Schlitze 21 angebracht. Dieses Rastnasen 28 greifen bei in die Bohrung 47 eingedrücktem Raststift 48 in Einschnitte am unteren Rand der Bohrung 47 oder an einem Hinterschnitt in der Bohrung 47 ein. Dieses hat zur Folge, dass diese Rastverbindung nur für eine bestimmte Stärke eines Solarmoduls geeignet ist. Diese Stärke ist durch den nach Einrasten der Rastnasen 28 vorgegebenen Spalt zwischen den Klemmflächen 13 an der Klemmkappe 40 und der Auflage 3 vorgegeben. Die Klemmkappe 40 ist auf ihrer Unterseite mit den Längsrillen 46 mit den Hinterschneidungen 43 versehen. Hinter diese Hinterschneidungen 43 greifen die am Insert 42 vorhandenen Widerhaken 44 ein, wenn die Klemmkappe 40 und damit der Raststift 48 in die Bohrung 47 eingedrückt ist.

Zur sicheren Befestigung ist bei dieser Ausführungsform das Insert 42 über die gesamte Länge der Bohung 47 ausgedehnt, so dass die Widerhaken 44 ebenfalls aus Kunststoff bestehen. Gleichzeitig sind am Insert 42 seitlich Ausleger 50 vorhanden, welche zur Festigkeit der Auflage 3 beitragen. Ein Stützblech ist hier nicht erforderlich.

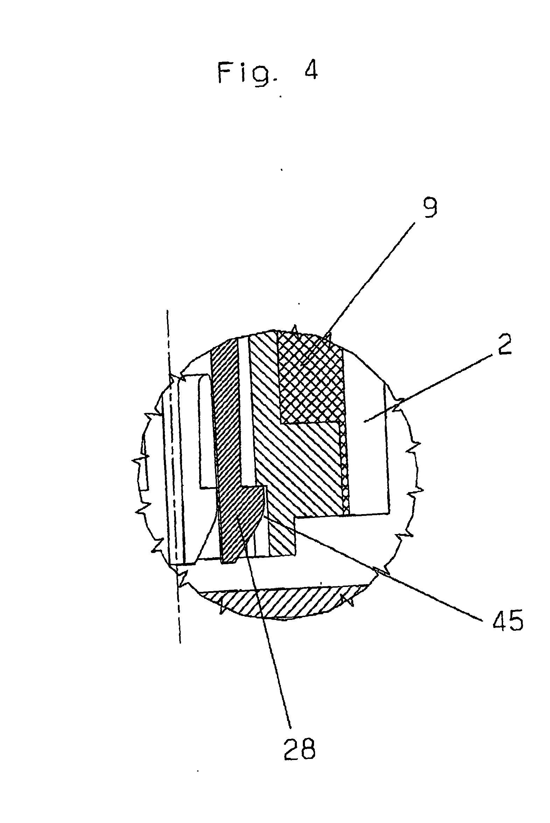

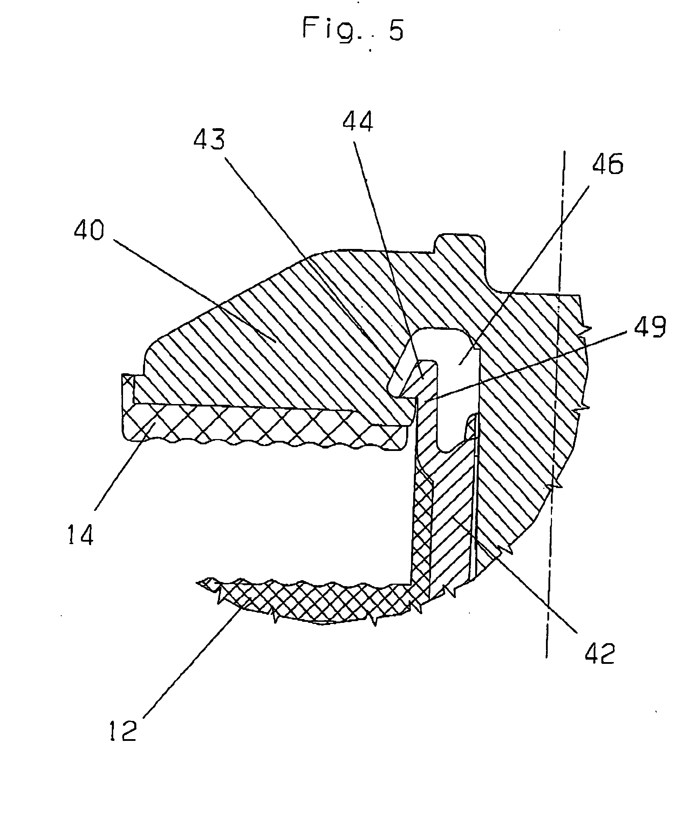

In den Fig. 4 und 5 sind vergrößerte Detallausführungen aus der Fig. 3 dargestellt. In der Fig. 4 ist das Einhaken einer Rastnase 28 an einem Hinterschnitt 43 am Insert 42 sichtbar.

Die Fig. 5 zeigt vergrößert die Querschnittsform einer Längsrille 46. In diese Längsrillen 46 kann eine am Insert 42 vorhandene leistenartige Verlängerung 49 eingeschoben werden. Diese Verlängerung 49 Ist mit den Widerhaken 44 versehen, welche hinter die Hinterschneidung 43 einklipsbar einrasten. Hierdurch wird die Klemmkappe 40 zusätzlich an der Auflage 3 gesichert. Der leistenartige Aufsatz 49 kann sich beim Aufsetzen der Klemmkappe 40 auf die Auflage 3 leicht seitwärts ausbiegen.

## Patentansprüche

1. Klemmverbindung (1) zur Befestigung von plattenförmigen Bauelementen, insbesondere von Solarmodulen auf schienenförmigen, mit Führungsnuten (5) mit nach innen in die Nut (5) überstehenden Rändern (6, 7) versehenen Trägem (2), aus einer Auflage (3) mit wenigstens einer auf ihrer Oberseite vorhandenen Auflagefläche (12) für ein Bauelement und mit einem die Auflagefläche (12) bzw. flächen (12) begrenzenden Stützbalken (15) sowie einem auf ihrer Unterseite vorhandenen Widerlager (9) in T-Form, dessen Querbalken (11) in Längsrichtung der Führungsnut (5) ausgerichtet in die Führungsnut (5) einsetzbar ist und nach einer Drehung um 90° die überstehenden Ränder (6, 7) der Führungsnut (5) hintergreifen, und aus einer Klemmkappe (4) mit die Auflagefläche (12) bzw. flächen (12) abdeckenden Klemmfläche (13) bzw. flächen (13) und einer den oberen Teil des Stützbalkens (15) erfassenden Längsnut (16), wobei die Klemmkappe (4) und die Auflage (3) über eine Rastverbindung (18, 19, 20, 28, 48) miteinander fixiert sind.

2. Klemmverbindung nach Anspruch 1, **dadurch gekennzeichnet, dass** die Rastverbindung (18, 19, 20, 28, 48) aus einem mit der Klemmkappe (4, 40) verbundenen Raststift (18, 48) besteht, der in eine Bohrung (17, 47) in der Auflage (3) eingedrückt dort fixiert ist.

3. Klemmverbindung nach Anspruch 1 oder 2, **dadurch gekennzeichnet, dass** der Raststift (18, 48) integral mit der Klemmkappe (4) verbunden ist.

4. Klemmverbindung nach Anspruch 1 bis 3, **dadurch gekennzeichnet, dass** der Raststift (18) eine Rastverzahnung (19) hat, die in eine in der Bohrung (17, 47) angebrachte kompatible Rastverzahnung (20) eingreift.

5. Klemmverbindung nach Anspruch 1 bis 4, **dadurch gekennzeichnet, dass** die Rastverzahnung (19, 20) am Raststift (18) und in der Bohrung (17) gegenläufig ausgerichtete Sägezähne haben.

6. Klemmverbindung nach Anspruch 1 bis 5, **dadurch gekennzeichnet, dass** der Raststift (18) über die Länge der Sägezähne mindestens einen Längsschlitz (21) hat

7. Klemmverbindung nach Anspruch 1 bis 6, **dadurch gekennzeichnet, dass** in die Bohrung (17) der Auflage (3) ein Insert (24, 42) eingefügt ist.

8. Klemmverbindung nach Anspruch 7, **dadurch gekennzeichnet, dass** das Insert (24, 42) aus einem Kunststoff besteht.

9. Klemmverbindung nach Anspruch 7 oder 8, **dadurch gekennzeichnet, dass** das Insert (24, 42) seitliche Ausleger (26) hat, die an der Unterseite des Querbalkens (11) des Wideriagers (9) anliegen.

10. Klemmverbindung nach Anspruch 7 bis 9, **dadurch gekennzeichnet, dass** das Insert (24, 42) mit seinem unteren Rand am Boden der Führungsnut (5) anliegt.

11. Klemmverbindung nach Anspruch 1 bis 4, **dadurch gekennzeichnet, dass** die Rastverbindung aus einem Raststift (48) besteht, der an seinem Ende Rastnasen (28) hat, die in Einschnitte am unteren Rand der Bohrung (47)
oder an einen Hinterschnitt (43) in der Bohrung (17) einrasten.

12. Klemmverbindung nach Anspruch 1 bis 11, **dadurch gekennzeichnet, dass** die Klemmkappe (4, 40) aus einem Kunststoff besteht.

13. Klemmverbindung nach Anspruch 12, **dadurch gekennzeichnet, dass** die Klemmfläche bzw. Klemmflächen der Klemmkappe (4, 40) einen Silikonüberzug (14) hat bzw. haben.

14. Klemmverbindung nach Anspruch 1 bis 13, **dadurch gekennzeichnet, dass** die Klemmkappe (40) auf ihrer Unterseite Längsrillen (46) mit Hinterschneidungen (43) hat, hinter welche am Stützbalken (48) an einer Leiste (49) vorhandene Widerhaken (44) einklipsbar einrasten.

15. Klemmverbindung nach Anspruch 1 bis 14, **dadurch gekennzeichnet, dass** die Auflage (3) aus einem Elastomer besteht.

16. Klemmverbindung nach Anspruch 1 bis 15, **dadurch gekennzeichnet, dass** die Auflage (3) mit einem Stützblech (41) ausgerichtet ist.

17. Klemmverbindung nach Anspruch 16, **dadurch gekennzeichnet, dass** das Stützblech (41) und das Insert (24) durch Vulkanisation mit der Auflage (3) verbunden sind.

## Claims

1. Clamping connection (1) for fastening components in the form of panels, in particular solar modules, on bearers (2) in the form of rails, provided with guiding grooves (5) with edges (6, 7) protruding inwards into the groove (5), comprising a rest (3) with at least one resting area (12), present on its upper side, for a component and with a supporting bar (15), delimiting the resting area (12) or areas (12), as well as an abutment (9), present on its underside, in the form of a T, the crossbar (11) of which is made to extend in the longitudinal direction of the guiding groove (5) and can be inserted into the guiding groove (5) and, after a rotation through 90°, engages behind the protruding edges (6, 7) of the guiding groove (5), and comprising a clamping cap (4) with a clamping area (13) or areas (13) covering the resting area (12) or areas (12), and a longitudinal groove (16), taking up the upper part of the supporting bar (15), the clamping cap (4) and the rest (3) being fixed to each other by means of a latching connection (18, 19, 20, 28, 48).

2. Clamping connection according to Claim 1, **characterized in that** the latching connection (18, 19, 20, 28, 48) comprises a latching pin (18, 48), which is connected to the clamping cap (4, 40) and, after being pushed into a bore (17, 47) in the rest (3), is fixed there.

3. Clamping connection according to Claim 1 or 2, **characterized in that** the latching pin (18, 48) is integrally connected to the clamping cap (4).

4. Clamping connection according to Claims 1 to 3, **characterized in that** the latching pin (18) has a latching serration (19), which engages in a compatible latching serration (20) provided in the bore (17, 47).

5. Clamping connection according to Claims 1 to 4, **characterized in that** the latching serrations (19, 20) on the latching pin (18) and in the bore (17) have oppositely directed saw teeth.

6. Clamping connection according to Claims 1 to 5, **characterized in that** the latching pin (18) has at least one longitudinal slit (21) over the length of the saw teeth.

7. Clamping connection according to Claims 1 to 6, **characterized in that** an insert (24, 42) is inserted into the bore (17) of the rest (3).

8. Clamping connection according to Claim 7, **characterized in that** the insert (24, 42) consists of a plastic.

9. Clamping connection according to Claim 7 or 8, **characterized in that** the insert (24, 42) has lateral extension pieces (26), which lie against the underside of the crossbar (11) of the abutment (9).

10. Clamping connection according to Claims 7 to 9, **characterized in that** the insert (24, 42) lies with its lower edge against the bottom of the guiding groove (5).

11. Clamping connection according to Claims 1 to 4, **characterized in that** the latching connection comprises a latching pin (48) which has at its end latching lugs (28), which latch in incisions on the lower edge of the bore (47) or on an undercut (43) in the bore (17).

12. Clamping connection according to Claims 1 to 11, **characterized in that** the clamping cap (4, 40) consists of a plastic.

13. Clamping connection according to Claim 12, **characterized in that** the clamping area or clamping areas of the clamping cap (4, 40) has or have a silicone coating (14).

14. Clamping connection according to Claims 1 to 13, **characterized in that** the clamping cap (40) has on its underside longitudinal channels (46) with undercuts (43), behind which barbs (44) present on a strip (49) latch in such a manner that they can clip into place on the supporting bar (48).

15. Clamping connection according to Claims 1 to 14, **characterized in that** the rest (3) consists of an elastomer.

16. Clamping connection according to Claims 1 to 15, **characterized in that** the rest (3) is aligned with a supporting plate (41).

17. Clamping connection according to Claim 16, **characterized in that** the supporting plate (41) and the insert (24) are connected to the rest (3) by vulcanization.

## Revendications

1. Liaison de serrage (1) pour la fixation de composants en forme de plaque, notamment de modules solaires, sur des supports (2) en forme de rail pourvus de rainures de guidage (5) dotées de bords (6, 7) faisant saillie vers l'intérieur dans la rainure (5), constituée d'un appui (3) doté d'au moins une surface d'appui (12) présente sur son côté supérieur pour un composant et doté d'une barre de support (15) limitant la surface d'appui (12) ou les surfaces d'appui (12) ainsi que d'une butée (9) en forme de T présente sur son côté inférieur, dont la barre transversale (11) peut être insérée dans la rainure de guidage (5) de manière orientée dans la direction longitudinale de la rainure de guidage (5) et, après une rotation de 90°, vient en prise par l'arrière avec les bords saillants (6, 7) de la rainure de guidage (5), et constituée d'un capuchon de serrage (4) doté d'une surface de serrage (13) ou de surfaces de serrage (13) recouvrant la surface d'appui (12) ou les surfaces d'appui (12) et doté d'une rainure longitudinale (16) saisissant la partie supérieure de la barre de support (15), le capuchon de serrage (4) et l'appui (3) étant fixés l'un à l'autre par le biais d'une liaison par encliquetage (18, 19, 20, 28, 48).

2. Liaison de serrage selon la revendication 1, **caractérisée en ce que** la liaison par encliquetage (18, 19, 20, 28, 48) est constituée d'une cheville d'encliquetage (18, 48) reliée au capuchon de serrage (4, 40), laquelle cheville d'encliquetage est enfoncée dans un alésage (17, 47) dans l'appui (3) et y est fixée.

3. Liaison de serrage selon la revendication 1 ou 2, **caractérisée en ce que** la cheville d'encliquetage (18, 48) est reliée d'un seul tenant au capuchon de serrage (4).

4. Liaison de serrage selon les revendications 1 à 3, **caractérisée en ce que** la cheville d'encliquetage (18) a une denture d'encliquetage (19) qui s'engrène dans une denture d'encliquetage compatible (20) installée dans l'alésage (17, 47).

5. Liaison de serrage selon les revendications 1 à 4, **caractérisée en ce que** les dentures d'encliquetage (19, 20) sur la cheville d'encliquetage (18) et dans l'alésage (17) ont des dents de scie orientées en sens contraires.

6. Liaison de serrage selon les revendications 1 à 5, **caractérisée en ce que** la cheville d'encliquetage (18) a au moins une fente longitudinale (21) sur la longueur des dents de scie.

7. Liaison de serrage selon les revendications 1 à 6, **caractérisée en ce qu'**un insert (24, 42) est inséré dans l'alésage (17) de l'appui (3).

8. Liaison de serrage selon la revendication 7, **caractérisée en ce que** l'insert (24, 42) est constitué d'un plastique.

9. Liaison de serrage selon la revendication 7 ou 8, **caractérisée en ce que** l'insert (24, 42) a des bras en porte-à-faux latéraux (26) qui s'appliquent contre le côté inférieur de la barre transversale (11) de la butée (9).

10. Liaison de serrage selon les revendications 7 à 9, **caractérisée en ce que** l'insert (24, 42) s'applique par son bord inférieur contre le fond de la rainure de guidage (5).

11. Liaison de serrage selon les revendications 1 à 4, **caractérisée en ce que** la liaison par encliquetage est constituée d'une cheville d'encliquetage (48) qui a des ergots d'encliquetage (28) à son extrémité, lesquels ergots d'encliquetage s'encliquètent dans des entailles sur le bord inférieur de l'alésage (47) ou sur une contre-dépouille (43) dans l'alésage (17).

12. Liaison de serrage selon les revendications 1 à 11, **caractérisée en ce que** le capuchon de serrage (4, 40) est constitué d'un plastique.

13. Liaison de serrage selon la revendication 12, **caractérisée en ce que** la surface de serrage ou les surfaces de serrage du capuchon de serrage (4, 40) a ou ont un revêtement en silicone (14).

14. Liaison de serrage selon les revendications 1 à 13, **caractérisée en ce que** le capuchon de serrage (40) a sur son côté inférieur des gorges longitudinales (46) dotées de contre-dépouilles (43) derrière lesquelles s'encliquètent de manière clipsable sur la barre de support (48) des crochets (44) présents sur une nervure (49).

15. Liaison de serrage selon les revendications 1 à 14, **caractérisée en ce que** l'appui (3) est constitué d'un élastomère.

16. Liaison de serrage selon les revendications 1 à 15, **caractérisée en ce que** l'appui (3) est aligné avec un tôle de support (41).

17. Liaison de serrage selon la revendication 16, **caractérisée en ce que** la tôle de support (41) et l'insert (24) sont reliés à l'appui (3) par vulcanisation.
